# EUROPEAN PATENT APPLICATION

(11) **EP 4 723 170 A1**
(43) Date of publication of application: **08.04.2026**
(21) Application number: 24822188.9
(22) Date of filing: 08.01.2024
(51) Int. Cl.: H01L 23/427

(54) **POWER MODULE CAPABLE OF RESISTING JUNCTION TEMPERATURE FLUCTUATION AND POWER DEVICE**

(30) Priority: 16.06.2023 CN 202310725863
(71) Applicant: Huawei Digital Power Technologies Co., Ltd., Shenzhen, Guangdong 518043 (CN)
(72) Inventor: WANG, Heng, Shenzhen, Guangdong 518043 (CN); HONG, Fangjun, Shenzhen, Guangdong 518043 (CN); HOU, Zhaozheng, Shenzhen, Guangdong 518043 (CN); LIAO, Xiaojing, Shenzhen, Guangdong 518043 (CN)
(74) Representative: Epping - Hermann - Fischer
(86) International application number: PCT/CN2024/071216
(87) International publication number: WO 2024/255227

(57) **Abstract**

This application provides a power device and a power module. The power module includes a phase change module and a chip, and the phase change module and the chip are stacked. The phase change module includes an accommodation frame and a phase change material. The accommodation frame includes at least two accommodation cavities. The at least two accommodation cavities are sequentially disposed in a direction away from a surface of the chip. The phase change material is disposed in the at least two accommodation cavities. The at least two accommodation cavities include a first accommodation cavity and a second accommodation cavity. A distance between the first accommodation cavity and the surface of the chip is less than a distance between the second accommodation cavity and the surface of the chip, and a phase change point of a phase change material in the first accommodation cavity is higher than a phase change point of a phase change material in the second accommodation cavity. In this solution, temperature distribution in a working condition of the chip is used, so that phase change materials in accommodation cavities at different distances to the surface of the chip can undergo a phase change, thereby improving heat absorption or energy storage effect and enhancing an ability of the power module to resist temperature junction fluctuation.

## Description

### TECHNICAL FIELD

This application relates to the field of electronic power technologies, and in particular, to a power module resistant to junction temperature fluctuation and a power device.

### BACKGROUND

In recent years, green energy increasingly develops, and gradually becomes a primary solution to an energy crisis. A power module, as a core component of green energy, is widely used. With rapid increase in an output power of a power conversion device, transient junction temperature fluctuation is increasingly large accordingly. Due to different thermal expansion coefficients of layers of materials in a power module of the power conversion device, junction temperature fluctuation results in problems such as solder layer fatigue and bonding wire detachment during long-time working, finally resulting in module failure and module reliability problems. Therefore, in an overload working condition, there is an increasing requirement for an ability of the power module to resist transient junction temperature fluctuation.

A phase change material (PCM: Phase Change Material) is a substance that changes a state and can provide latent heat when a temperature remains unchanged. A process in which the phase change material transits between a solid state, a liquid state, and a gaseous state is referred to as a phase change process. In this case, the phase change material absorbs or releases a large amount of latent heat. A manner of absorbing or releasing heat by the phase change material in the phase change process is referred to as latent heat storage, and has advantages of a high energy storage density, a constant temperature during energy storage and release, and recyclability. Therefore, the phase change material may be used in the power module field, to help resolve a problem of junction temperature fluctuation.

### SUMMARY

This application provides a power module resistant to junction temperature fluctuation and a power device. In this application, a phase change material is introduced into the power module, to redesign and optimize a structure of the power module, so that junction temperature fluctuation of the entire power module can be effectively suppressed, and heat dissipation performance of the power module can be improved. Adding the phase change material at a position close to a chip can effectively increase an equivalent heat capacity of the power module. The increase in heat capacity can effectively reduce junction temperature fluctuation of the chip and improve temperature equalization effect of the power module. In this application, an accommodation frame is disposed on a surface of the chip of the power module. A plurality of accommodation cavities are disposed in the accommodation frame, and a phase change material is filled in each accommodation cavity. Because distances from the accommodation cavities to the chip are not equal, and a temperature at a position farther away from the chip is lower based on temperature distribution of the chip during working, a phase change material with a higher phase change point is filled in an accommodation cavity closer to the chip, and a phase change material with a lower phase change point is filled in an accommodation cavity farther away from the chip, so that characteristics of different phase change points can be fully utilized. When power overload occurs in the chip, the phase change material in each accommodation cavity can undergo a phase change to absorb or store heat, thereby maximizing a heat capacity of the power module, effectively reducing junction temperature fluctuation of the chip, and improving temperature equalization effect of the power module.

Therefore, the following technical solutions are used in embodiments of this application.

According to a first aspect, an embodiment of this application provides a power module. The power module includes a phase change module and a chip, and the phase change module and the chip are stacked. The phase change module includes an accommodation frame and a phase change material, the accommodation frame includes at least two accommodation cavities, the at least two accommodation cavities are sequentially disposed in a direction away from a first surface of the chip, and the phase change material is disposed in the at least two accommodation cavities. The at least two accommodation cavities include a first accommodation cavity and a second accommodation cavity, a distance between the first accommodation cavity and the chip is less than a distance between the second accommodation cavity and the chip, and a phase change point of a phase change material in the first accommodation cavity is higher than a phase change point of a phase change material in the second accommodation cavity, where the first surface of the chip is perpendicular to a thickness direction of the power module.

It may be understood that, based on thermal imaging analysis of the chip, as a distance to a surface of the chip is increasingly large, a temperature around the chip is gradually reduced. To make full use of a phase change characteristic of the phase change material, a layered accommodation frame is used in this application, so that phase change materials with different phase change points are used in different accommodation cavities. A distance between the accommodation cavity and the chip is a distance between a geometric center of the accommodation cavity and a geometric center of the chip, or may be a distance between a geometric center of an accommodation wall of the accommodation cavity and a geometric center of a surface of the chip. For calculation of distances between different accommodation cavities and the chip, the distances should be distances between the accommodation cavities and a same surface of the chip. In addition, relative positions of the accommodation walls in the accommodation cavities are the same. Specifically, a phase change material with a higher phase change point is disposed in an accommodation cavity closer to the chip, and a phase change material with a lower phase change point is disposed in an accommodation cavity farther away from the chip, so that the phase change points of the phase change materials in the accommodation cavities exhibit a gradient distribution characteristic, which is consistent with a temperature distribution trend around the chip. When power consumption of the chip increases sharply due to power overload, the phase change materials in the accommodation cavities may reach the phase change points, so that the phase change materials undergo a phase change to absorb or store heat, thereby maximizing a heat capacity of the power module, effectively reducing junction temperature fluctuation of the chip, and improving temperature equalization effect of the power module.

With reference to the first aspect, in a first possible implementation, the at least two accommodation cavities are sequentially disposed in the thickness direction of the power module, a plane on which each accommodation cavity is located is parallel to the first surface of the chip, and the plane on which the accommodation cavity is located is a plane on which a surface that is in the surfaces of the accommodation cavities and that is perpendicular to the thickness direction of the power module is located. It may be understood that different accommodation cavities are parallel to each other, and are sequentially disposed in a direction away from the surface of the chip. This distribution manner of the accommodation cavities is approximately the same as a temperature distribution trend around the chip in a horizontal direction. This helps dispose phase change materials with different phase change points. The horizontal direction is a direction parallel to a surface that is of the chip and that is in the thickness direction of the power module.

With reference to the first aspect, in a second possible implementation, the at least two accommodation cavities are sequentially disposed in a first direction, a plane on which each accommodation cavity is located is perpendicular to the first surface of the chip, the first direction is perpendicular to the thickness direction of the power module, and the plane on which the accommodation cavity is located is a plane on which a surface that is in the surfaces of the accommodation cavities and that is perpendicular to the first direction is located. It may be understood that different accommodation cavities are parallel to each other, and are all perpendicular to the surface of the chip. This distribution manner of the accommodation cavities is approximately the same as a temperature distribution trend around the chip in a vertical direction. This helps dispose phase change materials with different phase change points. The vertical direction is a direction perpendicular to the surface that is of the chip and that is in the thickness direction of the power module.

With reference to the first aspect, in a third possible implementation, the at least two accommodation cavities are sequentially disposed in a first direction, a plane on which each accommodation cavity is located is perpendicular to the surface of the chip, each of the at least two accommodation cavities is annular, and the accommodation cavities are sequentially arranged from a center of the chip to an edge of the chip. It may be understood that temperatures at positions that are at a same distance to the geometric center of the chip should be approximately the same. A distribution manner of the annular accommodation cavities is approximately the same as a temperature distribution trend around the chip in a direction extending outward from the geometric center of the chip, and different accommodation cavities are sleeved on each other. This helps dispose phase change materials with different phase change points.

With reference to the first aspect, in a fourth possible implementation, each of the at least two accommodation cavities is hemispherical arc-shaped, and the accommodation cavities are sequentially arranged from a center of the surface of the chip to a direction away from the chip. It may be understood that temperatures at positions that are at a same distance to the chip should be approximately the same, and isotherms around the chip approximately form a hemispherical arc. A distribution manner of the hemispherical arc-shaped accommodation cavities is approximately the same as a temperature distribution trend around the chip, and different accommodation cavities are sleeved on each other. This helps dispose phase change materials with different phase change points.

With reference to the first aspect, in a fifth possible implementation, the phase change module includes a first phase change module, the first phase change module is disposed on the first surface of the chip, a second surface of the chip is configured to dispose a first heat sink, and the first surface and the second surface are disposed opposite to each other. It may be understood that the phase change material in the phase change module may increase thermal resistance, and therefore, disposal of the phase change material on the heat dissipation path is reduced, or the phase change module is disposed on a non-heat dissipation path. Respectively disposing the phase change module and the heat sink on two opposite surfaces that are of the chip and that are in the thickness direction of the power module can ensure heat dissipation effect of the power module.

With reference to the first aspect, in a sixth possible implementation, the accommodation frame of the first phase change module includes an electrical current path. The electrical current path is configured to provide a path for a current in the chip, the electrical current path is disposed on a side that is of the accommodation frame of the first phase change module and that is close to the chip, and content of phase change material per unit volume in the electrical current path is less than content of phase change material per unit volume in another part of the accommodation frame of the first phase change module. It may be understood that the phase change material in the first phase change module usually has poor electrical conductivity, and is not conducive to current conduction. Therefore, in the electrical current path in which a current flows, disposal of the phase change material is reduced, to improve electrical conductivity of the phase change module.

With reference to the first aspect, in a seventh possible implementation, no phase change material is disposed in the electrical current path. It may be understood that disposing no phase change material in the electrical current path can improve electrical conductivity of the phase change module to a maximum extent.

With reference to the first aspect, in an eighth possible implementation, the phase change module includes a second phase change module, and the second phase change module is disposed between the chip and the first heat sink. It may be understood that disposing the phase change module between the chip and the heat sink can reduce junction temperature fluctuation of the chip, and improve temperature equalization effect of the power module.

With reference to the first aspect, in a ninth possible implementation, an accommodation frame of the second phase change module includes a first heat dissipation part and a first phase change part, the first phase change part is disposed around the first heat dissipation part, and a projection that is of the first heat dissipation part and that is in a thickness direction of the chip overlaps the first surface of the chip; and content of phase change material per unit volume in the first heat dissipation part is less than content of phase change material per unit volume in the first phase change part. It may be understood that the first heat dissipation part is located on the heat dissipation path of the power module, and the phase change material in the phase change module may increase thermal resistance. Therefore, reducing disposal of the phase change material on the heat dissipation path can ensure heat dissipation effect of the power module.

With reference to the first aspect, in a tenth possible implementation, no phase change material is disposed in the first heat dissipation part. It may be understood that disposing no phase change material in the first heat dissipation part can improve heat dissipation efficiency of the power module to a maximum extent.

With reference to the first aspect, in an eleventh possible implementation, a surface that is of the first phase change module and that is away from the chip is configured to dispose a second heat sink; the accommodation frame of the first phase change module includes a second heat dissipation part and a second phase change part, the second phase change part is disposed around the second heat dissipation part, and a projection that is of the second heat dissipation part and that is in the thickness direction of the chip overlaps the first surface of the chip; and content of phase change material per unit volume in the second heat dissipation part is less than content of phase change material per unit volume in the second phase change part. It may be understood that the second heat dissipation part is located on the heat dissipation path of the power module, and the phase change material in the phase change module may increase thermal resistance. Therefore, reducing disposal of the phase change material on the heat dissipation path can ensure heat dissipation effect of the power module.

With reference to the first aspect, in a twelfth possible implementation, no phase change material is disposed in the second heat dissipation part. It may be understood that disposing no phase change material in the second heat dissipation part can improve heat dissipation efficiency of the power module to a maximum extent.

With reference to the first aspect, in a thirteenth possible implementation, a projection that is of the first phase change module and that is in the thickness direction of the power module covers the first surface of the chip. It may be understood that a projection area of the first phase change module is greater than an area of the first surface of the chip, so that more phase change material can be accommodated in the accommodation cavity, thereby increasing content of the phase change material in the power module, and further increasing the heat capacity of the power module. With reference to the first aspect, in a fourteenth possible implementation, the power module includes a metal brazed substrate, and the metal brazed substrate is stacked with the chip and is in contact with a surface of the chip; or the metal brazed substrate is disposed on a surface that is of the phase change module and that is away from the chip. Generally, the metal brazed substrate is a direct bond copper (Direct Bond Copper, DBC) ceramic substrate, an active metal brazed copper (Active metal brazed copper, AMB, for example, Al2O3-AMB, Si3N4-AMB, or AlN-AMB) substrate, an insulated metal substrate (Insulated metal substrate, IMS), or the like. For example, to further improve power density, the metal brazed substrate may be formed by using AlN-DBC, Si3N4-AMB, or AlN-AMB with high thermal conductivity. This is not limited herein.

With reference to the first aspect, in a fifteenth possible implementation, the phase change frame is a metal frame or a diamond frame, and the phase change material is any one or more of an elemental metal, an alloy, an organic compound, and an inorganic salt.

With reference to the first aspect, in a sixteenth possible implementation, the power module further includes a plastic package body, the chip and the phase change module are disposed in the plastic package body, or the chip is disposed in the plastic package body, and the phase change module is disposed outside the plastic package body.

With reference to the first aspect, in a seventeenth possible implementation, the at least two accommodation cavities communicate with each other.

According to a second aspect, an embodiment of this application provides a power device. The power device includes at least one power module according to the first aspect and a circuit board. The at least one power module is disposed on the circuit board, and the at least one power module is configured to perform alternating current/direct current conversion. It may be understood that the power device includes the power module in embodiments of this application according to the first aspect. Because the power module has a good characteristic of resisting junction temperature fluctuation, a chip can still maintain good temperature uniformity under power overload conditions, thereby improving working performance and stability of the power device during power overconsumption scenarios.

### BRIEF DESCRIPTION OF DRAWINGS

FIG. 1 is a diagram of a heat dissipation path of a current power module;
FIG. 2 is a Cauer RC thermal network model of a power module;
FIG. 3A to FIG. 3E are diagrams of a structure of a power module according to Embodiment 1;
FIG. 3F is a diagram of a three-dimensional structure of a phase change module in a power module according to Embodiment 1;
FIG. 4A is a diagram of a structure of a power module according to Embodiment 2;
FIG. 4B is a diagram of a three-dimensional structure of a phase change module in a power module according to Embodiment 2;
FIG. 5A is a diagram of a structure of a power module according to Embodiment 3;
FIG. 5B is a diagram of a three-dimensional structure of a phase change module in a power module according to Embodiment 3;
FIG. 6A is a diagram of a structure of a power module according to Embodiment 4;
FIG. 6B is a diagram of a three-dimensional structure of a phase change module in a power module according to Embodiment 4;
FIG. 7A to FIG. 7C are diagrams of a structure of a power module according to Embodiment 5;
FIG. 8A and FIG. 8B are diagrams of a structure of a power module according to Embodiment 6;
FIG. 8C is a diagram of a structure of a power module according to Embodiment 7;
FIG. 9A and FIG. 9B are diagrams of a structure of a power module according to Embodiment 8;
FIG. 10 is a diagram of a structure of a power module according to Embodiment 9; and
FIG. 11 is a diagram of a structure of a power module according to Embodiment 10.

### Reference numerals:

1: substrate; 2: silicone grease; 3: substrate connection layer; 4: chip connection layer; 5: plastic package body; 30: chip; 30': chip; 40 and 41: heat sinks; 60: metal brazed substrate; 10: phase change frame; 10': phase change frame; 11 to 18: accommodation cavities; 71 to 76: accommodation cavities; 01 to 06: accommodation cavities; 11' to 13': accommodation cavities; 71' to 76': accommodation cavities; 21 to 28: phase change materials; 81 to 86: phase change materials; 91 to 96: phase change materials; 21' to 23': phase change materials; and 81' to 86': phase change materials.

### DESCRIPTION OF EMBODIMENTS

The following describes the technical solutions in embodiments of this application with reference to the accompanying drawings in embodiments of this application.

A power module plays an important role in a power device, and is a core component of the power device in fields such as new energy vehicles and smart photovoltaics. When the power device works, a chip in the power module implements alternating current/direct current conversion through frequent state switching between on and off. As the industry develops toward a high-voltage scenario, the power module develops toward a high-voltage direction accordingly. The power module usually works in an overload working condition, for example, acceleration and deceleration of a new energy electric vehicle, and start and stop of high-voltage power generation of a smart photovoltaic. This result in junction temperature fluctuation in the power module. The power module is formed by stacking and connecting different materials, and a thermal expansion coefficient of the material inside varies greatly. When a temperature changes, thermal stress aging is generated between connection layers that are connected to each other in the module, causing reliability problems such as solder layer fatigue or bonding wire detachment. The junction temperature fluctuation has a great impact on a service life of the module. Reducing the junction temperature fluctuation of the power module is of great significance to improve reliability of the module in an application scenario with frequent power fluctuation.

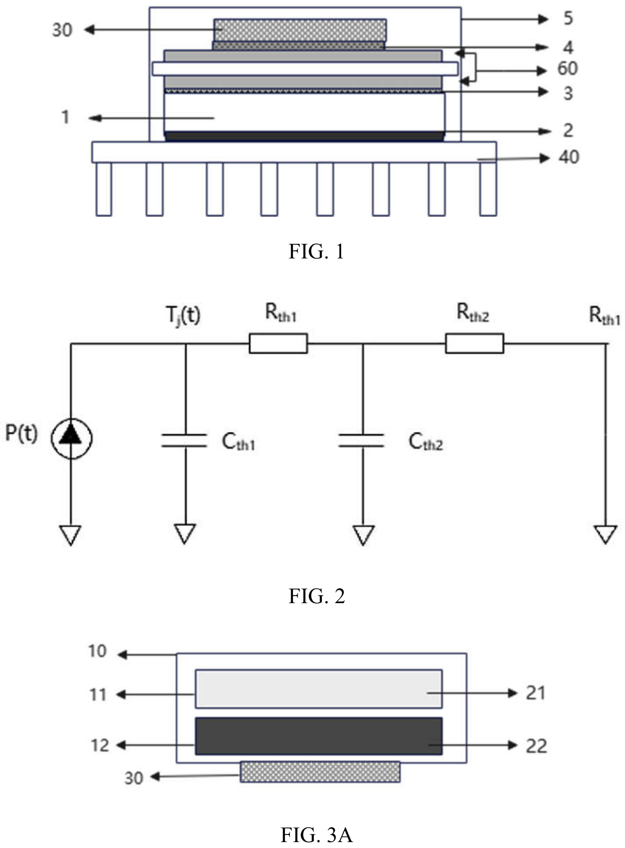

A structure of the power module is usually shown in FIG. 1. A chip 30 is soldered to a metal brazed substrate 60 by using solder, then the metal brazed substrate 60 is soldered to the substrate 1 to form internal package of the module, and the module is packaged through a plastic package body 5. The power module is connected to a heat sink 40 by using thermally conductive silicone grease 2. When the power module works, the chip 30 generates a heat loss. Heat is transferred to the heat sink 40 through the metal brazed substrate 60, the substrate 1, and the silicone grease 2, and is dissipated through active heat dissipation or passive heat dissipation. Generally, a junction temperature of the chip 30 in the power module does not exceed an allowed highest temperature. Based on a Cauer RC thermal network model of the power module, as shown in FIG. 2, when power fluctuates, the junction temperature fluctuation of the power module is reduced in two ways: reducing thermal resistance R on a heat dissipation path of the power module, and increasing an internal heat capacity C of the power module.

The thermal resistance on the heat dissipation path is mainly reduced by reducing thermal resistance of a contact material between different components. For example, the module and the heat sink can be connected to each other through silver sintering. This process is mature and has been commercially applied. Currently, research in the industry focuses on how to increase a heat capacity of the power module and reduce the junction temperature fluctuation of the power module. Application of a phase change material is a mainstream direction for increasing the heat capacity on the heat dissipation path. The phase change material (PCM: Phase Change Material) absorbs or releases heat during a phase change to keep a temperature unchanged, and dQ/dT is equivalent to infinity, that is, an equivalent heat capacity is infinite. Therefore, the phase change material has a higher value for increasing the heat capacity. The phase change material has been used in the field of thermal management such as heat sinks in the field of integrated circuits. However, excessively long temperature response time of the phase change material limits cooling effect of the phase change material to a specific extent. To resolve this problem, a copper block of a special structure is added between a chip and a DBC, and a groove is provided inside the copper block to fill the phase change material, so as to absorb latent heat in a phase change process of the phase change material. In this design, in an overload working condition of the power module, only a part of the phase change material usually undergoes a phase change, and consequently heat absorption performance of the phase change material during the phase change is not fully utilized. Therefore, a new power module structure needs to be sought, so that a module can quickly respond to a junction temperature change when power fluctuates, to reduce a junction temperature fluctuation amplitude and improve reliability of the power module.

To resolve the foregoing problem, this application provides a new power module and a power device. It can be learned through analysis of a heat map of the chip in a working state that a temperature at a position closer to the chip is higher, and a temperature around the chip is gradually reduced in a direction from a center of the chip to a direction away from the chip. To fully utilize a temperature distribution status of the chip, a phase change frame is disposed at a position close to the chip. Disposing a plurality of accommodation cavities at positions with different distances to the chip in the phase change frame, and disposing phase change materials with different phase change points in different accommodation cavities may enable the phase change materials with different phase change points to undergo a phase change, so that utilization of the phase change materials is maximized.

A first embodiment provided in this application is shown in FIG. 3A. The first embodiment of this application provides a power module. The power module includes a chip 30 and a phase change frame 10. The phase change frame 10 includes two accommodation cavities, specifically, an accommodation cavity 11 and an accommodation cavity 12. The accommodation cavity 11 and the accommodation cavity 12 are sequentially disposed in a direction away from a first surface of the chip 30. A phase change material 21 is disposed in the accommodation cavity 11, and a phase change material 22 is disposed in the accommodation cavity 12. A distance between the accommodation cavity 12 and the chip 30 is less than a distance between the accommodation cavity 11 and the chip 30, and a phase change point of the phase change material 22 in the accommodation cavity 12 is higher than a phase change point of the phase change material 21 in the accommodation cavity 11. The phase change point of the phase change material 22 is equal to a temperature of the chip 30 at the accommodation cavity 12 in an overload working condition, and the phase change point of the phase change material 21 is equal to a temperature of the chip 30 at the accommodation cavity 11 in the overload working condition. Note: The equality herein further includes approximate equality, and does not necessarily mean complete equality, for example, with a difference of 1% to 10%. Based on the foregoing disposal, when the chip 30 works in the overload working condition, both the phase change material 21 and the phase change material 22 can undergo a phase change, so that energy can be absorbed or stored to a maximum extent, a heat capacity of the power module is increased, and effect of the power module in resisting junction temperature fluctuation is improved.

The accommodation cavity 11 and the accommodation cavity 12 are cuboids having a specific height in a thickness direction of the power module. Surfaces that are of the accommodation cavity 11 and the accommodation cavity 12 and that are in the thickness direction of the power module are both parallel to a surface that is of the chip 30 and that is in the thickness direction of the power module. A plane on which the accommodation cavity is located is a plane on which a surface that is of the accommodation cavity and that is in the thickness direction of the power module is located. In a feasible implementation, projections that are of the accommodation cavity 11 and the accommodation cavity 12 and that are in the thickness direction of the power module cover a projection that is of the chip 30 and that is in the thickness direction of the power module. This disposal can increase a phase change area of the phase change frame, thereby improving effect of resisting junction temperature fluctuation. Certainly, a size of the phase change frame may alternatively be set based on a junction temperature fluctuation status of the chip. For a chip with small junction temperature fluctuation, the phase change frame may be reduced, so that projection areas that are of the accommodation cavity 11 and the accommodation cavity 12 and that are in the thickness direction of the power module are less than a projection area that is of the chip 30 and that is in the thickness direction of the power module.

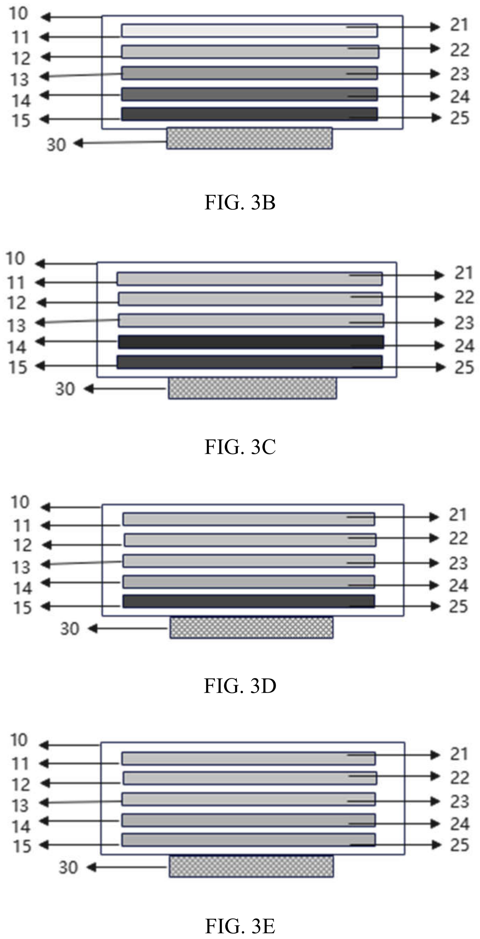

In some feasible embodiments, the phase change frame 10 may include more than two accommodation cavities. As shown in FIG. 3B, the phase change frame 10 includes five accommodation cavities in which phase change materials with different phase change points are respectively disposed. Specifically, a phase change material 21 is disposed in an accommodation cavity 11, a phase change material 22 is disposed in an accommodation cavity 12, a phase change material 23 is disposed in an accommodation cavity 13, a phase change material 24 is disposed in an accommodation cavity 14, and a phase change material 25 is disposed in an accommodation cavity 15. Distances from the accommodation cavity 11, the accommodation cavity 12, the accommodation cavity 13, the accommodation cavity 14, and the accommodation cavity 15 to the chip 30 are sequentially reduced, and phase change points of the phase change material 21, the phase change material 22, the phase change material 23, the phase change material 24, and the phase change material 25 are sequentially increased. The phase change points of the phase change material 21, the phase change material 22, the phase change material 23, the phase change material 24, and the phase change material 25 may be specifically set based on the temperature distribution of the chip 30 in an overload working condition, so that the phase change material in each accommodation cavity can undergo a phase change, thereby maximizing a heat capacity of the power module.

In addition, different accommodation cavities may communicate with or may be separated from each other, and specific settings may be adjusted based on an application scenario. The accommodation frame 10 may be made of metal or diamond. The diamond has better heat dissipation effect, but higher costs. A frame material may be flexibly selected based on an actual requirement. The phase change material may be any one or more of an elemental metal, an alloy, an organic compound, and an inorganic salt, and may be selected based on temperature distribution of the chip 30 under an actual working condition.

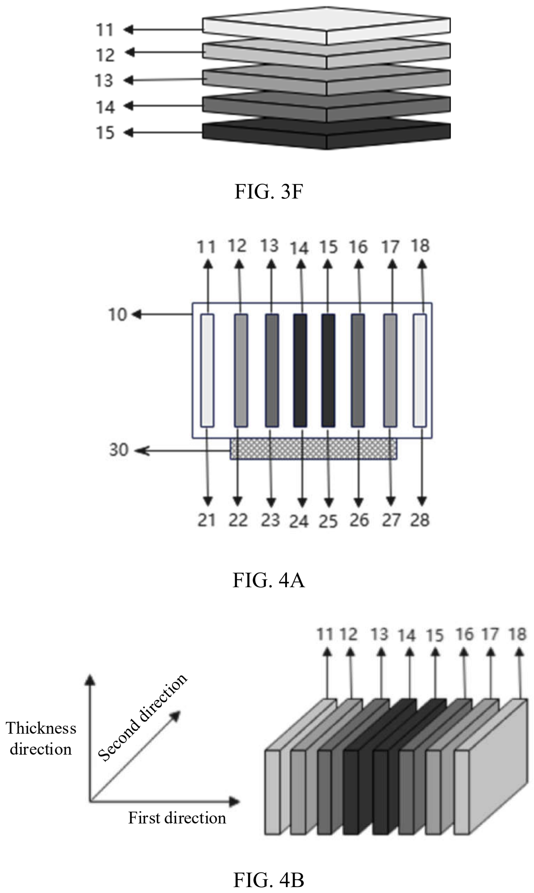

In some feasible embodiments, based on an actual temperature distribution status of the chip 30, phase change points of phase change materials in accommodation cavities may not necessarily be different. As different phase change cavities are increasingly far away from the chip 30, phase change points of the corresponding phase change materials in the accommodation cavities are required to be gradually reduced. As shown in FIG. 3C, disposal of the accommodation cavity is the same as that in FIG. 3B, but disposal of the phase change material is different. Specifically, phase change points of the phase change material 21, the phase change material 22, and the phase change material 23 are the same, and phase change points of the phase change material 24 and the phase change material 25 are the same. The phase change points of the phase change material 21, the phase change material 22, and the phase change material 23 are smaller than the phase change points of the phase change material 24 and the phase change material 25. Similarly, as shown in FIG. 3D, disposal of the accommodation cavity is the same as that in FIG. 3B, but disposal of the phase change material is different. Specifically, phase change points of the phase change material 21, the phase change material 22, the phase change material 23, and the phase change material 24 are the same, and a phase change point of the phase change material 25 is different from the phase change points of the other four phase change materials. The phase change points of the phase change material 21, the phase change material 22, the phase change material 23, and the phase change material 24 are smaller than the phase change point of the phase change material 25. Further, in some implementations, as shown in FIG. 3E, disposal of the accommodation cavity is the same as that in FIG. 3B, and disposal of phase change material are different. Specifically, phase change points of the phase change material 21, the phase change material 22, the phase change material 23, the phase change material 24, and the phase change material 25 are the same. In other words, phase change materials with a same phase change point are discretely disposed, to improve utilization of the phase change materials, and further increase a heat capacity of the power module. FIG. 3F is a diagram of a three-dimensional structure of the phase change frame. The accommodation cavity 11, the accommodation cavity 12, the accommodation cavity 13, the accommodation cavity 14, and the accommodation cavity 15 are cuboids having a specific height in a thickness direction of the power module. The accommodation cavity 11, the accommodation cavity 12, the accommodation cavity 13, the accommodation cavity 14, and the accommodation cavity 15 are sequentially disposed in the thickness direction of the power module, and surfaces that are of the accommodation cavity 11, the accommodation cavity 12, the accommodation cavity 13, the accommodation cavity 14, and the accommodation cavity 15 and that are in the thickness direction of the power module are all parallel to a surface that is of the chip 30 and that is in the thickness direction of the power module.

In a second embodiment, as shown in FIG. 4A, accommodation cavities in a phase change frame are spaced from each other, and a plane on which each accommodation cavity is located is perpendicular to a surface of a chip 30. A three-dimensional shape of the accommodation cavity is shown in FIG. 4B. A plane on which the accommodation cavity is located is a plane on which a surface that is in the surfaces of the accommodation cavities and that is perpendicular to a first direction is located. The plane on which the accommodation cavity is located is perpendicular to a surface that is of the chip 30 and that is in the thickness direction of the power module, and extends in a second direction. The first direction, the second direction, and the thickness direction of the power module are perpendicular to each other.

A phase change frame 10 includes an accommodation cavity 11, an accommodation cavity 12, an accommodation cavity 13, an accommodation cavity 14, an accommodation cavity 15, an accommodation cavity 16, an accommodation cavity 17, and an accommodation cavity 18. The accommodation cavity 11 and the accommodation cavity 18 are symmetrically disposed, the accommodation cavity 12 and the accommodation cavity 17 are symmetrically disposed, the accommodation cavity 13 and the accommodation cavity 16 are symmetrically disposed, and the accommodation cavity 14 and the accommodation cavity 15 are symmetrically disposed. Symmetrical disposal means that different accommodation cavities are at an equal distance from the chip 30, and are symmetrically disposed on two sides of a geometric center of the chip 30. Distances from the accommodation cavity 11 and the accommodation cavity 18, the accommodation cavity 12 and the accommodation cavity 17, the accommodation cavity 13 and the accommodation cavity 16, and the accommodation cavity 14 and the accommodation cavity 15 to the surface of the chip 30 are sequentially reduced. Herein, the distance from the chip 30 is a distance from a geometric center of each accommodation cavity or a geometric center of an accommodation wall to a geometric center of a surface of the chip 30.

Phase change materials with different phase change points are disposed in the accommodation cavities. Specifically, a phase change material 21 is disposed in the accommodation cavity 11, a phase change material 22 is disposed in the accommodation cavity 12, a phase change material 23 is disposed in the accommodation cavity 13, a phase change material 24 is disposed in the accommodation cavity 14, a phase change material 25 is disposed in the accommodation cavity 15, a phase change material 26 is disposed in the accommodation cavity 16, a phase change material 27 is disposed in the accommodation cavity 17, and a phase change material 28 is disposed in the accommodation cavity 18. The phase change material 21 and the phase change material 28 have a same phase change point, the phase change material 22 and the phase change material 27 have a same phase change point, the phase change material 23 and the phase change material 26 have a same phase change point, and the phase change material 24 and the phase change material 25 have a same phase change point. The phase change point of the phase change material 21 and the phase change material 28, the phase change point of the phase change material 22 and the phase change material 27, the phase change point of the phase change material 23 and the phase change material 26, and the phase change point of the phase change material 24 and the phase change material 25 are sequentially increased. The phase change points of the phase change material 21, the phase change material 22, the phase change material 23, the phase change material 24, the phase change material 25, the phase change material 26, the phase change material 27, and the phase change material 28 may be specifically set based on temperature distribution of the chip 30 in an overload working condition, so that the phase change material in each accommodation cavity can undergo a phase change, thereby maximizing a heat capacity of the power module.

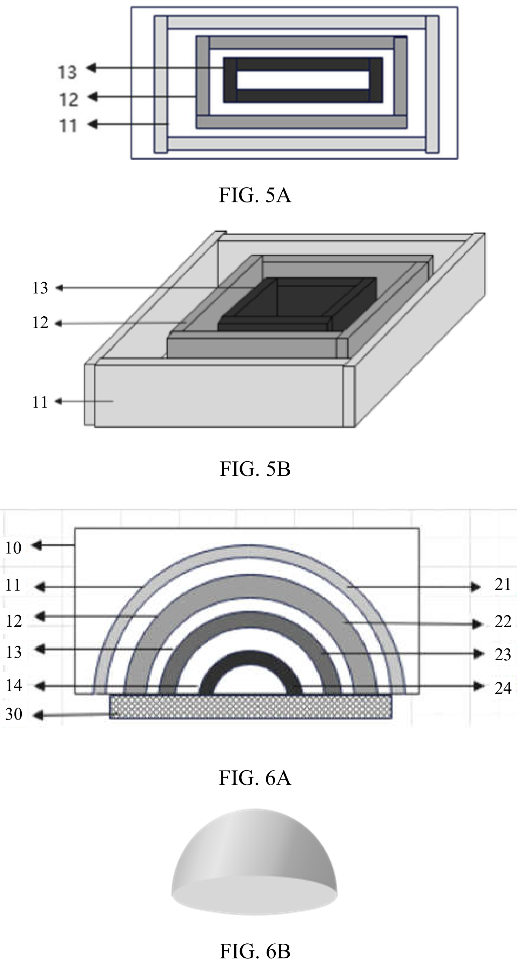

In a third embodiment, as shown in FIG. 5A and FIG. 5B, accommodation cavities in a phase change frame 10 are annular three-dimensional structures, and are sequentially arranged from a center of the chip 30 to an edge of the chip 30. Planes on which side walls of the accommodation cavities are located are perpendicular to a surface of the chip 30. Temperatures at positions that are at a same distance to the chip 30 should be approximately the same, a distribution manner of the annular accommodation cavities is approximately the same as a temperature distribution trend around the chip 30 in a direction extending outward from a geometric center of the surface of the chip 30, and different accommodation cavities are sleeved on each other. As shown in FIG. 5A and FIG. 5B, a joint between adjacent side walls of each accommodation cavity is right-angle-shaped. Generally, a joint between different accommodation cavities may alternatively be arc-shaped.

The phase change frame 10 includes an accommodation cavity 11, an accommodation cavity 12, and an accommodation cavity 13. The accommodation cavity 11, the accommodation cavity 12, and the accommodation cavity 13 are nested with each other. Four side walls of each of the accommodation cavity 11, the accommodation cavity 12, and the accommodation cavity 13 are symmetrically disposed relative to a surface center of the chip 30, and a plane on which the four side walls of each of the accommodation cavity 11, the accommodation cavity 12, and the accommodation cavity 13 are located is perpendicular to a surface that is of the chip 30 and that is in a thickness direction of the power module. Phase change materials with different phase change points are disposed in the accommodation cavity 11, the accommodation cavity 12, and the accommodation cavity 13 respectively. Specifically, a phase change material 21 is disposed in the accommodation cavity 11, a phase change material 22 is disposed in the accommodation cavity 12, and a phase change material 23 is disposed in the accommodation cavity 13. Distances from the accommodation cavity 11, the accommodation cavity 12, and the accommodation cavity 13 to the chip 30 are sequentially reduced, and phase change points of the phase change material 21, the phase change material 22, and the phase change material 23 are sequentially increased. The phase change points of the phase change material 21, the phase change material 22, and the phase change material 23 may be specifically set based on temperature distribution of the chip 30 in an overload working condition, so that the phase change material in each accommodation cavity can undergo a phase change, thereby maximizing a heat capacity of the power module.

In a fourth embodiment, as shown in FIG. 6A and FIG. 6B, accommodation cavities in a phase change frame 10 are hemispherical arc-shaped three-dimensional structures, and are arranged from a center of the chip 30 to an edge of the chip 30. Different accommodation cavities are nested with each other, and opening directions of the accommodation cavities all face a surface that is of the chip 30 and that is in a thickness direction of the power module. Temperatures at positions that are at a same distance to the chip 30 should be approximately the same. A distribution manner of the hemispherical arc-shaped accommodation cavities is approximately the same as a temperature distribution trend around the chip 30 in a direction extending outward from a geometric center of the chip 30.

The phase change frame 10 includes an accommodation cavity 11, an accommodation cavity 12, an accommodation cavity 13, and an accommodation cavity 14. The accommodation cavity 11, the accommodation cavity 12, the accommodation cavity 13, and the accommodation cavity 14 are all hemispherical arc-shaped, and the accommodation cavities are nested with each other. A section of a plane on which each of the accommodation cavity 11, the accommodation cavity 12, the accommodation cavity 13, and the accommodation cavity 14 and a surface that is of the chip 30 and that is in the thickness direction of the power module are located is annular, and a center of each annular shape approximately coincides with a center of a surface of the chip 30. Phase change materials with different phase change points are respectively disposed in the accommodation cavity 11, the accommodation cavity 12, the accommodation cavity 13, and the accommodation cavity 14. Specifically, a phase change material 21 is disposed in the accommodation cavity 11, a phase change material 22 is disposed in the accommodation cavity 12, a phase change material 23 is disposed in the accommodation cavity 13, and a phase change material 24 is disposed in the accommodation cavity 14. Distances from arc walls of the accommodation cavity 11, the accommodation cavity 12, the accommodation cavity 13, and the accommodation cavity 14 to the chip 30 are sequentially reduced, and phase change points of the phase change material 21, the phase change material 22, the phase change material 23, and the phase change material 24 are sequentially increased. Temperatures at positions that are at a same distance to the surface of the chip 30 and that are on the hemispherical arc are approximately the same, and isotherms around the chip approximately form a hemispherical arc. A distribution manner of the hemispherical arc-shaped accommodation cavities is approximately the same as a temperature distribution trend around the chip, and different accommodation cavities are sleeved on each other. This helps dispose phase change materials with different phase change points, and improve utilization of the phase change materials.

Embodiments 1 to 4 describe in detail the shapes and distributions of the accommodation cavities in the phase change frame 10. It should be noted that the shapes and distributions of the accommodation cavities in the phase change frame 10 are not limited to the foregoing four cases. To further make the setting of the accommodation cavity be consistent with temperature distribution in a working condition of the chip 30, the accommodation cavity may be further divided, the accommodation cavity is set as grid-shaped, and the accommodation cavity is further divided into a plurality of sub-accommodation cavities. For example, the accommodation cavity 11 in Embodiment 2 is divided into a plurality of grid structures in the second direction and the thickness direction. Phase change materials with different phase change points may be further disposed in the refined accommodation cavities, to improve utilization of the phase change materials.

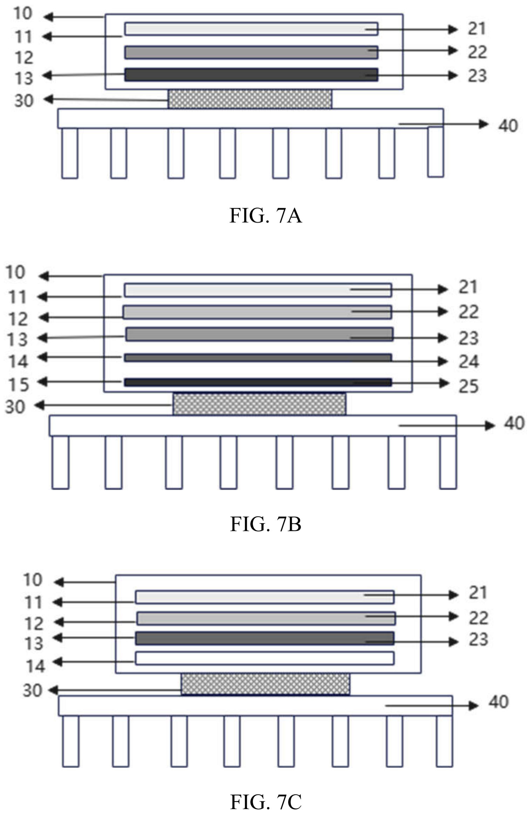

In a fifth embodiment, generally, a power module needs to cooperate with a heat sink to take out heat in a chip through the heat sink. As shown in FIG. 7A, a first heat sink 40 is disposed on a second surface of the chip 30, and a phase change module includes a first phase change module. Due to poor heat dissipation effect of a phase change material, disposal of the phase change material may be reduced as much as possible on a heat dissipation path. Therefore, the first phase change module is disposed on a first surface of the chip 30, so that the first phase change module is in contact with the first surface of the chip 30, and the heat sink is disposed on a second surface opposite to the first surface of the chip 30. This helps improve heat dissipation effect.

Generally, a current flows on the first surface of the chip 30, and therefore the current in the chip 30 flows through an accommodation frame. Due to poor conductivity of the phase change material, an electrical current path is disposed in the accommodation frame 10, to make the accommodation frame 10 provide a better electrical current path for the chip 30. The electrical current path is configured to provide a path for the current in the chip 30. The electrical current path is disposed on a side that is of the accommodation frame 10 of the phase change module and that is close to the chip. Content of phase change material per unit volume in the electrical current path is less than content of phase change material per unit volume in other parts of the accommodation frame 10. As shown in FIG. 7B, the accommodation frame 10 includes an accommodation cavity 11, an accommodation cavity 12, an accommodation cavity 13, an accommodation cavity 14, and an accommodation cavity 15. The electrical current path is at an approximate position on which the accommodation cavity 14 and the accommodation cavity 15 in the accommodation frame 10 are located. In terms of height of the accommodation cavity, heights of the accommodation cavity 14 and the accommodation cavity 15 in a thickness direction of the power module are less than heights of the accommodation cavity 11, the accommodation cavity 12, and the accommodation cavity 13 in the thickness direction of the power module. Volumes of the accommodation cavity 14 and the accommodation cavity 15 are also less than volumes of the accommodation cavity 11, the accommodation cavity 12, and the accommodation cavity 13. Therefore, content of phase change materials in the accommodation cavity 14 and the accommodation cavity 15 is less than content of phase change materials in the accommodation cavity 11, the accommodation cavity 12, and the accommodation cavity 13. Further, as shown in FIG. 7C, the accommodation frame 10 includes an accommodation cavity 11, an accommodation cavity 12, an accommodation cavity 13, and an accommodation cavity 14. An electrical current path is at an approximate position on which the accommodation cavity 14 in the accommodation frame 10 is located. No phase change material is disposed in the accommodation cavity 14. In terms of height of the accommodation cavity, a height of the accommodation cavity 14 in the thickness direction of the power module may be the same as or different from heights of other accommodation cavities. Further, no accommodation cavity may alternatively be disposed at a position of the accommodation cavity 14, to maximize use of conductive performance of the accommodation frame and improve a current-conducting capability of the electrical current path.

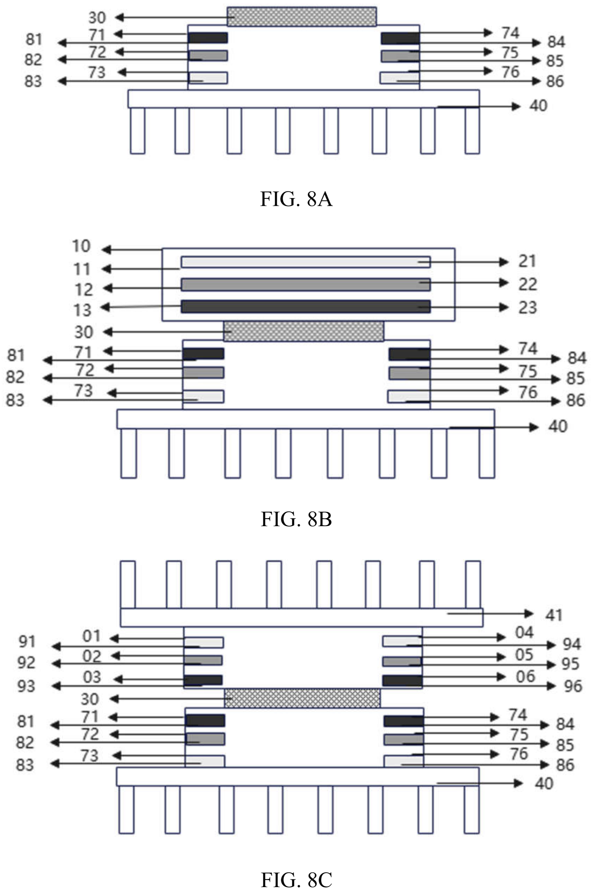

In a sixth embodiment, as shown in FIG. 8A, when a power module needs to cooperate with a heat sink, a phase change module further includes a second phase change module, and the second phase change module is disposed between a chip 30 and a first heat sink 40. Because the second phase change module is disposed on a heat dissipation path of the chip 30, and a phase change material affects heat transfer, disposal of the phase change material on the heat dissipation path is avoided as much as possible. An accommodation frame 10 of the second phase change module includes a first heat dissipation part and a first phase change part, the first phase change part is disposed around the first heat dissipation part, and a projection that is of the first heat dissipation part and that is on a thickness of the power module overlaps a first surface of the chip 30. Content of phase change material per unit volume in the first heat dissipation part is less than content of phase change material per unit volume in the first phase change part. Further, no phase change material is disposed in the first heat dissipation part.

The first phase change part includes an accommodation cavity 71, an accommodation cavity 72, an accommodation cavity 73, an accommodation cavity 74, an accommodation cavity 75, and an accommodation cavity 76, and planes on which the accommodation cavity 71, the accommodation cavity 72, the accommodation cavity 73, the accommodation cavity 74, the accommodation cavity 75, and the accommodation cavity 76 are located are parallel to a surface of the chip 30. The surface of the chip 30 may be the first surface or a second surface of the chip 30. The accommodation cavity 71 and the accommodation cavity 74 are disposed on a same plane, the accommodation cavity 72 and the accommodation cavity 75 are disposed on a same plane, and the accommodation cavity 73 and the accommodation cavity 76 are disposed on a same plane. Phase change materials in the accommodation cavity 71 and the accommodation cavity 74 have a same phase change point, phase change materials in the accommodation cavity 72 and the accommodation cavity 75 have a same phase change point, and phase change materials in the accommodation cavity 73 and the accommodation cavity 76 have a same phase change point. The phase change point of the phase change material may be set based on temperature distribution in a working condition of the chip 30.

To fully increase a heat capacity of the power module, a phase change module may be disposed on both the first surface and the second surface of the chip 30. As shown in FIG. 8B, the first phase change module is disposed on the first surface of the chip 30, and the second phase change module is disposed on the second surface of the chip 30. For disposal of the accommodation cavity and the phase change material in the first phase change module, refer to disposal of the first phase change module in FIG. 7A in Embodiment 5. For disposal of the accommodation cavity and the phase change material in the second phase change module, refer to disposal of the second phase change module in FIG. 8A in Embodiment 6.

In a seventh embodiment, for a power module with double-sided heat dissipation, as shown in FIG. 8C, the phase change module includes a first phase change module and a second phase change module. The first phase change module is disposed on a first surface of the chip 30, and the second phase change module is disposed on a second surface of the chip 30. A surface that is of the first phase change module and that is away from the chip 30 is configured to dispose a second heat sink 41, and a surface that is of the second phase change module and that is away from the chip 30 is configured to dispose a first heat sink 40. For disposal of an accommodation cavity and a phase change material in the first phase change module and the second phase change module, refer to disposal of the second phase change module in FIG. 8A in Embodiment 7.

In some feasible implementations, to increase a heat capacity of the power module, a relative area of the phase change module to the chip 30 may be further increased, so that a projection of the first phase change module or the second phase change module in a thickness direction of the power module covers the first surface of the chip 30. Herein, disposal of the accommodation cavity and the phase change material in the first phase change module or the second phase change module is not limited, and may be any disposal of the phase change module in Embodiment 1 to Embodiment 6.

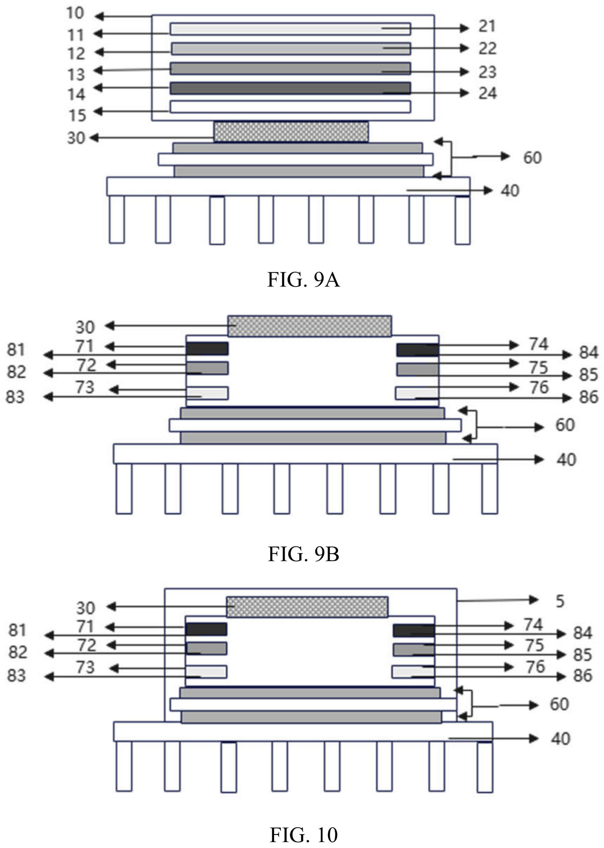

In an eighth embodiment, as shown in FIG. 9A, a power module further includes a metal brazed substrate 60. The metal brazed substrate 60 may be disposed on a surface of the chip 30, and the metal brazed substrate 60 is in contact with the surface of the chip 30. A phase change module is disposed on another surface of the chip 30, and is disposed opposite to the metal brazed substrate 60. A heat sink 40 is disposed on a side that is of the metal brazed substrate 60 and that is away from the chip 30. Heat generated by the chip 30 is taken away by the heat sink 40 through the metal brazed substrate 60. The metal brazed substrate may be a three-layer substrate like a direct bond copper (Direct Bond Copper, DBC) ceramic substrate, an active metal brazed copper (Active metal brazed copper, AMB, for example, Al2O3-AMB, Si3N4-AMB, or AlN-AMB) substrate, or an insulated metal substrate (Insulated metal substrate, IMS). The upper and lower layers of the three-layer substrate are made of a conductive and thermally conductive material. The lower layer close to a power chip may provide a channel for flow of a current inside the power chip, or may also guide out heat generated by the power chip in time. The upper layer close to the heat sink may mainly protect the power chip, and reduce impact of external collision on the power chip. The middle layer is an insulated layer, and may avoid a connection between the conductive and thermally conductive material of the lower layer and the heat sink, and avoid a problem like a short circuit of the chip. However, the lower layer of the three-layer substrate, for example, the DBC, is usually connected to the power chip through a copper layer. The copper layer of the lower layer is thin, and has limited effect on improving transient thermal performance. As a result, an effective heat diffusion area of the lower layer is small, and steady-state thermal performance is not optimal. In some feasible embodiments, as shown in FIG. 9B, the phase change module is disposed between the chip 30 and the heat sink 40, and the metal brazed substrate 60 is disposed on a surface that is of the phase change module and that is away from the chip 30. Heat generated by the chip 30 is conducted to the metal brazed substrate 60 through a heat dissipation part of the phase change module, and is finally taken away by the heat sink 40.

In a ninth embodiment, as shown in FIG. 10, a power module further includes a plastic package body 5, where a chip 30, a phase change module, and a metal brazed substrate 60 are packaged in the plastic package body 5, and the chip 30, the phase change module, and the metal brazed substrate 60 are sequentially stacked. A unified packaging manner improves overall structural integrity of the power module.

The power module may include a plurality of packaging manners. In some feasible implementations, a side that is of the chip 30 and that is away from the phase change module is exposed on an outer surface of the plastic package body 5, and a surface that is of the chip 30 and that is away from the phase change module is flush with the outer surface of the plastic package body 5.

In some feasible implementations, the power module further includes a plastic package body 5. A chip 30 and a metal brazed substrate 60 are disposed in the plastic package body 5. The chip 30 and the metal brazed substrate 60 are stacked. A surface that is of the metal brazed substrate 60 and that is away from the chip 30 is configured to dispose a heat sink 40. The phase change module is disposed outside the plastic package body 5, and is disposed on a side that is of the chip 30 and that is away from the metal brazed substrate 60.

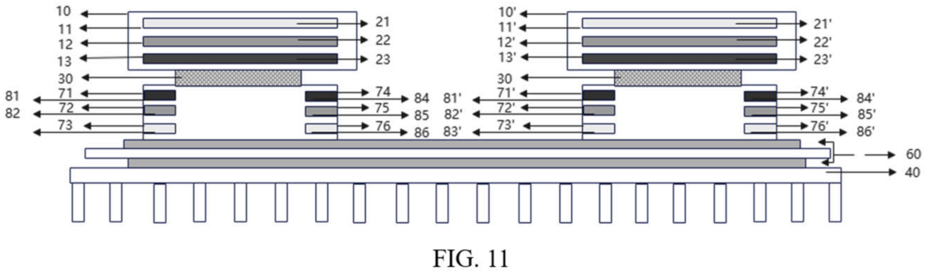

In some feasible implementations, no corresponding diagram is provided in this application. The power module further includes a plastic package body 5. A chip 30 is disposed in the plastic package body 5. One side that is of the chip 30 and that is in a thickness direction of the power module is configured to dispose a heat sink 40, and the other side that is of the chip 30 and that is in the thickness direction of the power module is configured to dispose the phase change module. In a tenth embodiment, as shown in FIG. 11, a power module may include two chips: a chip 30 and a chip 30'. The chip 30 and the chip 30' are disposed on a same metal brazed substrate 60. A side that is of the metal brazed substrate 60 and that is away from the chip 30 and the chip 30' is configured to dispose a heat sink 40. In some feasible implementations, the chip 30 and the chip 30' may be disposed on different metal brazed substrates.

In an eleventh embodiment, a power device is provided. The power device includes at least one power module according to any one of the foregoing embodiments and a circuit board. The power module is disposed on the circuit board. The power device is configured for alternating current/direct current conversion. In this embodiment of this application, for a structure and a working principle of the power module, refer to the descriptions of the foregoing embodiments. Details are not described again in embodiments of this application.

Generally, the power device provided in this embodiment of this application uses the power module in the foregoing embodiments. The power module has a phase change module, which increases a heat capacity of the power module, and improves temperature fluctuation resistance performance of the power module. The chip can still maintain a good temperature under power overload conditions, thereby improving working performance and stability of the power device during power overconsumption scenarios.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises a phase change module and a chip, and the phase change module and the chip are stacked;
the phase change module comprises an accommodation frame and a phase change material, the accommodation frame comprises at least two accommodation cavities, the at least two accommodation cavities are sequentially disposed in a direction away from a first surface of the chip, and the phase change material is disposed in the at least two accommodation cavities; and
the at least two accommodation cavities comprise a first accommodation cavity and a second accommodation cavity, a distance between the first accommodation cavity and the chip is less than a distance between the second accommodation cavity and the chip, and a phase change point of a phase change material in the first accommodation cavity is higher than a phase change point of a phase change material in the second accommodation cavity, wherein the first surface of the chip is perpendicular to a thickness direction of the power module.

2. The power module according to claim 1, wherein the at least two accommodation cavities are sequentially disposed in the thickness direction of the power module, a plane on which each accommodation cavity is located is parallel to the first surface of the chip, and the plane on which the accommodation cavity is located is a plane on which a surface that is in the surfaces of the accommodation cavities and that is perpendicular to the thickness direction of the power module is located.

3. The power module according to claim 1, wherein the at least two accommodation cavities are sequentially disposed in a first direction, a plane on which each accommodation cavity is located is perpendicular to the first surface of the chip, the first direction is perpendicular to the thickness direction of the power module, and the plane on which the accommodation cavity is located is a plane on which a surface that is in the surfaces of the accommodation cavities and that is perpendicular to the first direction is located.

4. The power module according to claim 3, wherein each of the at least two accommodation cavities is annular, and the accommodation cavities are sequentially arranged from a center of the chip to an edge of the chip.

5. The power module according to any one of claims 1 to 4, wherein the phase change module comprises a first phase change module, the first phase change module is disposed on the first surface of the chip, a second surface of the chip is configured to dispose a first heat sink, and the first surface and the second surface are disposed opposite to each other.

6. The power module according to claim 5, wherein the accommodation frame of the first phase change module comprises an electrical current path, the electrical current path is configured to provide a path for a current in the chip, the electrical current path is disposed on a side that is of the accommodation frame of the first phase change module and that is close to the chip, and content of phase change material per unit volume in the electrical current path is less than content of phase change material per unit volume in another part of the accommodation frame of the first phase change module.

7. The power module according to claim 6, wherein no phase change material is disposed in the electrical current path.

8. The power module according to any one of claims 1 to 7, wherein the phase change module comprises a second phase change module, and the second phase change module is disposed between the chip and the first heat sink;
an accommodation frame of the second phase change module comprises a first heat dissipation part and a first phase change part, the first phase change part is disposed around the first heat dissipation part, and a projection that is of the first heat dissipation part and that is in a thickness direction of the chip overlaps the first surface of the chip; and
and content of phase change material per unit volume in the first heat dissipation part is less than content of phase change material per unit volume in the first phase change part.

9. The power module according to claim 8, wherein no phase change material is disposed in the first heat dissipation part.

10. The power module according to any one of claims 5 to 9, wherein a surface that is of the first phase change module and that is away from the chip is configured to dispose a second heat sink;
the accommodation frame of the first phase change module comprises a second heat dissipation part and a second phase change part, the second phase change part is disposed around the second heat dissipation part, and a projection that is of the second heat dissipation part and that is in the thickness direction of the chip overlaps the first surface of the chip; and
content of phase change material per unit volume in the second heat dissipation part is less than content of phase change material per unit volume in the second phase change part.

11. The power module according to any one of claims 5 to 10, wherein a projection that is of the first phase change module and that is in the thickness direction of the power module covers the first surface of the chip.

12. The power module according to any one of claims 1 to 11, wherein the power module comprises a metal brazed substrate, and the metal brazed substrate is stacked with the chip and is in contact with a surface of the chip; or
the metal brazed substrate is disposed on a surface that is of the phase change module and that is away from the chip.

13. The power module according to any one of claims 1 to 12, wherein the phase change frame is a metal frame or a diamond frame, and the phase change material is any one or more of an elemental metal, an alloy, an organic compound, and an inorganic salt.

14. A power device, wherein the power device comprises at least one power module according to any one of claims 1 to 13 and a circuit board, and the power module is disposed on the circuit board.
